Europäisches Patentamt

(19) European Patent Office

Office européen des brevets

(11) Publication number: **0 090 081
B1**

(12) **EUROPEAN PATENT SPECIFICATION**

(45) Date of publication of patent specification: 27.05.87

(21) Application number: **82110811.5**

(22) Date of filing: **23.11.82**

(51) Int. Cl.⁴: **C 23 C 14/34,** C 23 C 14/50,
G 11 B 5/193

(54) **Process for depositing films on both sides of a plurality of thin substrates.**

(30) Priority: **26.03.82 US 362425**

(43) Date of publication of application:
**05.10.83 Bulletin 83/40**

(45) Publication of the grant of the patent:
**27.05.87 Bulletin 87/22**

(84) Designated Contracting States:
**DE FR GB IT**

(56) References cited:
**EP-A-0 030 625
DE-A-2 420 430
DE-A-2 903 872
GB-A-2 022 306
US-A-4 192 253
US-A-4 222 345**

**PATENT ABSTRACTS OF JAPAN, unexamined
applications, C field, vol. 4, no. 119, August 23,
1980, THE PATENT OFFICE JAPANESE
GOVERNMENT, page 153 C 22**

**IBM TECHNICAL DISCLOSURE BULLETIN, vol.
23, no. 11, April 1981, page 5149**

(73) Proprietor: **International Business Machines
Corporation
Old Orchard Road
Armonk, N.Y. 10504 (US)**

(72) Inventor: **Burkhart, Robert Wayne
1040 East Camino de los Padres
Tucson Arizona 85718 (US)**
Inventor: **Cox, Allen Ronald
3, The Deanery
Chandler's Ford Hampshire (GB)**
Inventor: **Hartley, John Dennis
129, Downs Road South Wonston
Winchester Hampshire (GB)**

(74) Representative: **Ahlman, Bertel et al
IBM Svenska AB Intellectual Property
Department Box 962
S-18 109 Lidingö (SE)**

Courier Press, Leamington Spa, England.

## Description

This invention relates to a process for depositing films on both sides of a plurality of thin magnetic head substrates. A particular, but not exclusive, application is to the preparation of ferrite cores for incorporation in magnetic head assemblies.

Magnetic head assemblies which incorporate ferrite cores are widely used in audio, video and data processing systems. Ferrite is known to be brittle and, therefore, during machining and shaping as well as during operation in the sensing of magnetic media, the ferrite edges and corners can be chipped and otherwise eroded. As the ferrite cores are made smaller and narrower to increase data track density, the chipping and erosion problem increases exponentially. Life and output decrease, thereby adding significantly to the cost of maintenance because the heads have to be replaced, and to costs of production because the chipped ferrite cores must be rejected.

Ferrite cores have been assembled with ceramic supports or glass layers to add to the structural strength. It has been found as noted in EP—A—0030625 and US—A—4,298,899, that layers of alumina films deposited on the sides of the ferrite core before insertion into a magnetic head assembly provide a support to the edges of the ferrite core during the lapping process to determine the throat height for the head as well as providing an edge support during the reading and writing of magnetic transitions from magnetic media. However, the deposition of the alumina was performed on one side at a time which led to stressing of the ferrite cores due to the thermal mismatch of the ferrite material and the alumina. This stress is compounded when the alumina is then deposited on the opposite side. This stress decreased the magnetic properties of the ferrite core. Thus the deposition material on the sides of the ferrite core to prevent edge corrosion led to a problem of thermal mismatch between the ferrite core and the deposited material during the deposition process, resulting in stress.

In IBM Technical Disclosure Bulletin Vol. 23, No. 11, April 1981, page 5149, it is proposed to accomplish vapour deposition of alumina on a thin ferrite substrate by positioning the ferrite substrate vertically in the vacuum chamber and orthogonally with reference to the electrode from which the alumina particles are released in the high temperature environment of the vacuum chamber.

Problems arise in the implementation of this proposed deposition method to a plurality of ferrite cores simultaneously, and it is the object of this invention to provide an effective method of depositing substantially equal thickness films on both sides of a plurality of thin substrates simultaneously.

The present invention is defined in the attached claims.

Accordingly a process for depositing films on both sides of a plurality of thin magnetic head substrates is disclosed, the process comprising the steps of:

placing a plurality of said substrates in a vacuum deposition sputtering apparatus around a circle into recesses of an annular stationary fixture, with an air bearing surface of each substrate being exposed, with the sides of each substrate perpendicular to a circular target of the film material to be deposited and such that the surfaces of both sides of each substrate are essentially positioned on a radius of the circle, with the particle deposition centre of the system being the centre of the circle,

pumping down the sputtering apparatus with a vacuum pump,

operating the sputtering apparatus to sputter etch the sides of the placed substrates,

operating the vacuum deposition sputtering apparatus so that a film layer of the target material is deposited on all exposed surfaces of the thus placed substrates, and

removing the substrates from the apparatus after the required film thickness is obtained from the operated apparatus.

The invention will now be described with reference to the accompanying drawings, in which:

FIGURE 1 is a perspective view of a magnetic head assembly incorporating a ferrite core processed according to the present invention;

FIGURE 2 is a schematic representation of a diode sputtering apparatus used in the performance of the present invention;

FIGURE 3 is a top plan view of an anode and substrate support fixture for performing the deposition process according to the present invention;

FIGURE 4 is a cross-sectional view on the line IV—IV of Fig. 3;

FIGURE 5 is a perspective view of a ferrite core processed according to the present invention for inclusion in the magnetic head assembly of Fig. 1.

The description is directed towards methods of depositing onto both sides of thin magnetic head substrates in a vacuum deposition sputtering apparatus. The preferred embodiment is directed towards a method of producing ferrite cores using the steps of the invention. In the preferred embodiment of making ferrite cores for magnetic head assemblies, the ferrite cores are first produced by standard methods and then a film of alumina is deposited on both sides of the ferrite cores in one sputter deposition operation. The preferred ferrite cores are essentially thin substrates which are placed in a specific pattern in a vacuum deposition sputtering apparatus for accomplishment of the present invention.

The sputter deposition of a thin film of material on both sides of thin magnetic head substrates is performed by positioning the substrate sides orthogonal to the target and radial to the target or cathode of the sputter apparatus. The vapour deposition of alumina on thin ferrite cores for magnetic head assemblies is accomplished by positioning the ferrite substrates in the vacuum chamber orthogonally to the target surface and radial to the particle deposition centre. The alumina is deposited on both sides of the ferrite cores simultaneously to substantially the same thickness. The deposition on both sides of the ferrite cores protects the cores against width erosion, and minimizes bending stress. In addition, signal output of the ferrite cores when used in magnetic head assemblies is increased.

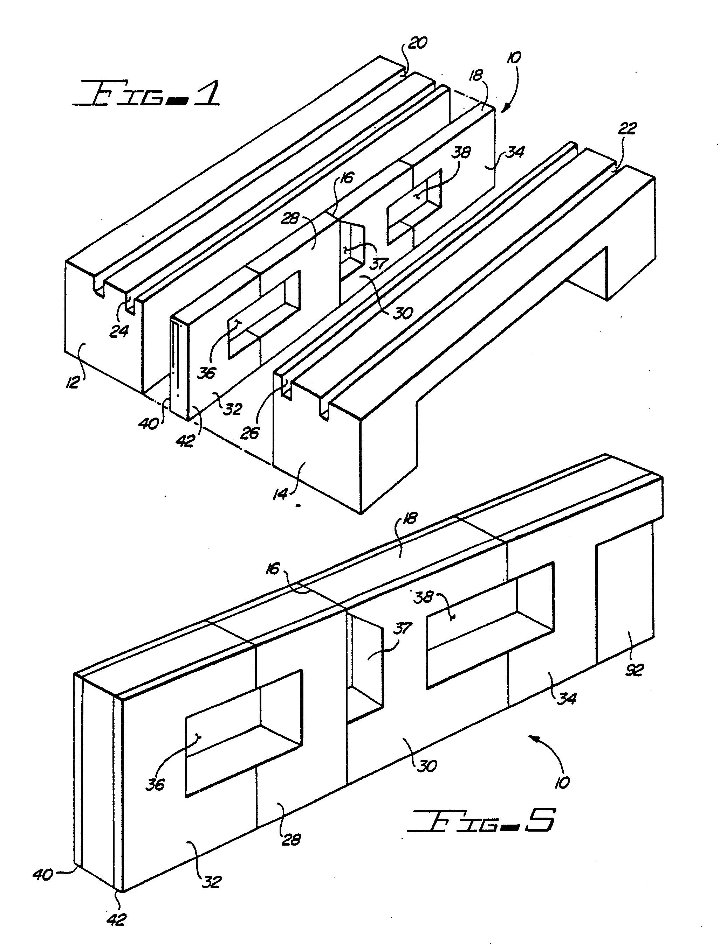

A magnetic head slider assembly (Fig. 1) includes a ferrite core 10 which is sandwiched between two configured ceramic slabs 12 and 14. The ferrite core 10 has a transducing gap 16 located on one edge of the ferrite core 10 which is formed to be an air bearing surface 18. The ceramic slabs 12 and 14, which may be formed from barium titanate ceramic, by way of example, each have respective outer and inner slotted portions 20 and 22, 24 and 26 formed in the same surface as air bearing surface 18. These slots form rails that provide a configuration for affording relatively close flying height of the head slider assembly and the transducing gap 16 relative to a moving magnetic medium.

The ferrite core 10 includes two ferrite blocks 28 and 30 which form the transducing gap 16. Ceramic blocks 32 and 34 are bonded to the free edges of the ferrite pieces 28 and 30, respectively, to form the ferrite core 10. The ferrite core 10 includes apertures 36, 37 and 38. An electrical coil is wound about the ferrite piece 28 or 30 through the apertures 36 and 37, or through the apertures 37 and 38 after the sandwich-type head assembly formed by ceramic blocks 12 and 14 encompassing the ferrite core 10 is bonded together. The winding of the electrical core and the formation of the head assembly is performed in a well known manner and need not be further described herein.

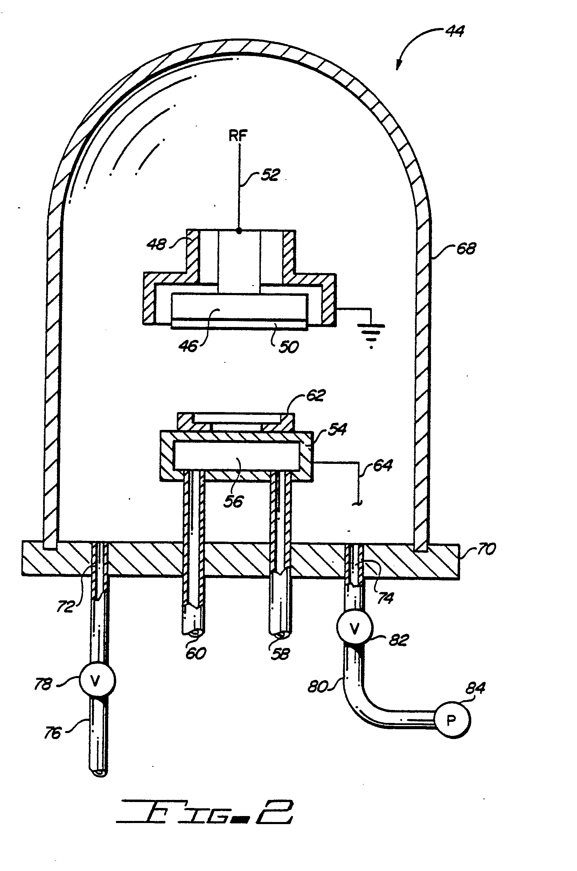

The ferrite core 10 includes films 40 and 42, preferably of alumina, vacuum deposited on each side. These films 40 and 42 must be of a very hard material which is why alumina is preferred. The films 40 and 42 provide the necessary support to the brittle ferrite pieces 28 and 30 of the ferrite core 10. The films 40 and 42 prevent chipping and erosion of the various pieces in the ferrite core 10 that may occur during the processing steps of the ferrite core or during the operation of the head slider assembly with relation to the moving magnetic medium, which may be a magnetic tape, for example. The films 40 and 42 are sputter deposited in a vacuum deposition apparatus such as shown in Fig. 2.

The sputter deposition apparatus (Fig. 2) includes a first electrode 46, the cathode assembly formed also to function as a heat sink, surrounded by a shield 48. Bonded to the surface of the cathode assembly 46 is a circular layer of the alumina material forming the target 50. Coupled to the cathode assembly 46 is an RF lead 52 of a power supply (not shown).

Below the target 50 is placed, in substantially parallel spaced relation thereto, a circular anode assembly 54 which includes a housing through which a cooling fluid 56, such as water, flows by way of inlet 58 and outlet 60. On the surface of the anode assembly 54 is a fixture 62. A lead 64 is connected to the anode assembly 54. The anode assembly may be placed at an electrical ground via lead 64, or maintained at a bias voltage via an RF lead at substantially lower voltage than the cathode.

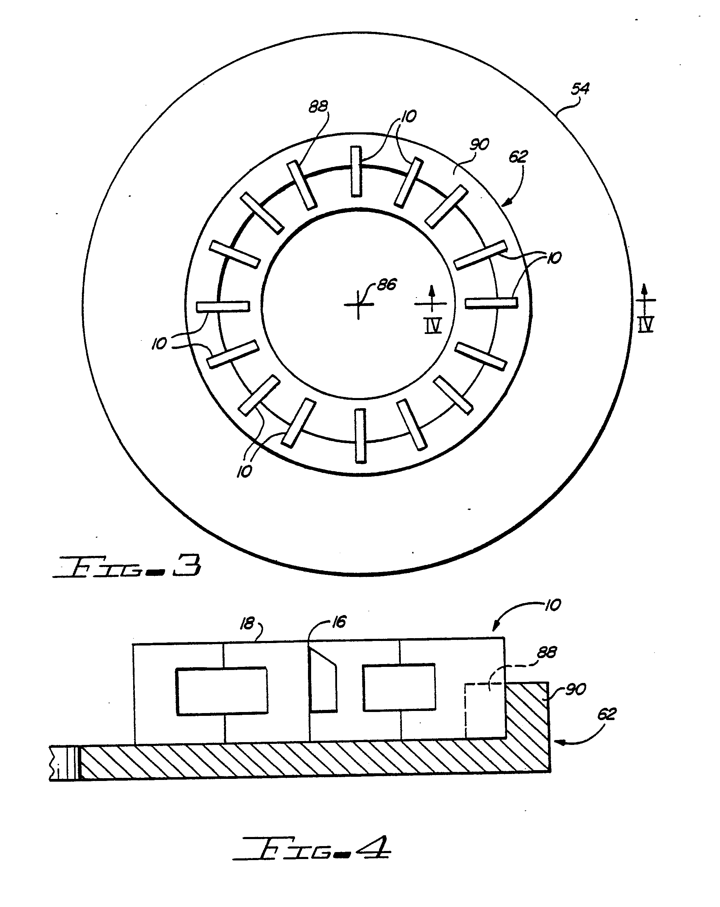

Enclosing the electrodes is a bell jar 68 which in turn rests on a base member 70. Base 70 includes two ports 72 and 74. The first port 72 is an inlet for a suitable gas directed into the bell jar 68 via a conduit 76 under control of a gas control valve 78. Argon, for example, furnishes the necessary ionized particles for bombarding the surface of the target 50. The second port 74 connects to a second conduit 80 which in turn is controlled by a valve 82 and is coupled to a vacuum pump 84. The vacuum pump 84 serves to maintain the environment within the bell jar at a vacuum pressure for the sputter deposition operation. The fixture 62 is for holding the very thin substrates during the procedure according to the present invention and is shown in Figs. 3 and 4.

The fixture 62 (Fig. 3) is formed as an annular ring having a plurality of very thin substrates shown as the ferrite cores 10 mounted around the top surface of the fixture 62. The ferrite cores 10 are mounted so that the surfaces of both sides of the cores are perpendicular to the particle deposition surface whose centre is identified by reference numeral 86 with those surfaces radially positioned with respect to the particle deposition centre 86. A plurality of ferrite cores is mounted on the fixture 62 so as to provide an economical operation because a plurality of very thin substrates have the film of alumina deposited on their exposed surfaces in one pump down of the sputter apparatus. The position of the ferrite cores 10 in a circle, with the sides of the ferrite cores positioned essentially on a radius of the circle with the centre of the circle being the particle deposition centre 86, provides an effective deposition processing position wherein essentially equal amounts of the target material are deposited on each side of each of the ferrite cores 10. Each of the sides of the substrates have opposing points the same distance away from the deposition centre. The vertical orientation establishes perpendicularity because the common orientation of the sputter deposition apparatus is with the target and anode assembly in the horizontal position.

Each ferrite core 10 (Fig. 4) is mounted in a radial recess 88 formed in an upright flange 90 around the periphery of the fixture 62, in which is a plurality of such slots 88. The height of the flange 90 is less than the height of the core 10. This upright position allows the sputtering apparatus 44 of Fig. 2 to deposit the material, preferably alumina, from the target 50 onto all exposed edges and sides of the ferrite core 10. Portions 92 (Fig. 5) of the ferrite core 10 placed into the slot 88 and the lower edge on the fixture 92 are not covered by the alumina material. All other edges are covered by the alumina material, including the air bearing surface 18. The alumina is not desired on the air bearing surface 18 because this would position the transducing gap 16 a further distance away from the magnetic medium and would result in a lowering of the output from the magnetic head. Thus the ferrite core 10 is lapped to remove the alumina coating from the air bearing surface 18 before the ferrite core is included as part of the magnetic head assembly.

The finished ferrite core 10 (Fig. 5) for inclusion into a magnetic head assembly has the thin films 40 and 42 of alumina deposited onto both sides of the ferrite core 10, except for the portions 92 which are placed within the slot 88 in the upright portion 90 of the fixture 62. The portions 92 can be removed from the ferrite core 10 or can be compensated for by the bonding material such as glass when the ferrite core 10 is placed in the sandwich structure (Fig. 1). The uncoated portions 92 do not effect the operation of the ferrite core 10 because the entire lengths of the edges of the air bearing surface 18 include the edge protection provided by the thin film alumina layers 40 and 42. The thus protected ferrite core is then included into the magnetic head slider assembly (Fig. 1) for further processing to produce an eventual total magnetic head package according to the procedures well known in the prior art.

Prior to film deposition, the sides of the ferrite cores are subject to non-mechanical etching as described in EP—A—0030625.

For the formation of edge-protected ferrite cores for magnetic heads, each ferrite core is first produced by edge joining the magnetic ferrite blocks 28 and 30 to form a transducing gap 16. Next, the ceramic blocks 32 and 34 supporting the ferrite blocks are edge attached to form a ferrite core 10 by bonding the non-magnetic ceramic blocks to the joined ferrite magnetic blocks. The ferrite cores are then loaded into the fixture 62 so that the air bearing surfaces of the ferrite cores are exposed with the sides of the ferrite cores mounted in a vertical direction relative to the base of the fixture and radially directed towards the centre of the fixture. The fixture is then loaded onto the anode assembly 54 of the sputter deposition apparatus so that the ends of the ferrite core are perpendicular to and their sides radially directed towards the deposition centre of the sputter deposition apparatus. The sputter deposition apparatus is then pumped down, and the sides of the ferrite cores subjected to sputter etching for 25 minutes. The sputter deposition apparatus is then activated to deposit a target material, preferably alumina, onto all the exposed surfaces of the ferrite cores. The fixture with the thin film deposited ferrite cores is then removed after the sputter procedure and the air bearing surfaces are then lapped to remove the thin film of alumina material.

Each very thin ferrite core has a thickness of approximately 0.1 mm (four thousandths of an inch) with the film of alumina deposited onto the sides of the ferrite cores being in the range from 1.27 to 5.08 μm (50 to 200 micro-inches) by way of example. The sputtering system operates at a target or cathode power of 500 to 900 watts with a −50 to −100 volts bias voltage applied to the anode or substrate holder. The deposition is carried on for approximately 36 hours to obtain a deposition of 5.08 μm (200 micro-inches) of alumina films on the sides of the ferrite cores. The argon pressure is approximately 1.3 Pa (0.01 TORR). The anode to cathode spacing is approximately 25.4 mm (one inch). The argon flow is set at 100 cubic centimetres per minute. The system was originally pumped down to $2.6 \times 10^{-4}$ Pa $(2 \times 10^{-6}$ TORR).

One of the advantages of depositing according to the present invention is that both sides are deposited having the same thickness on all the substrates.

Other shapes of thin flat magnetic head substrates can be treated by the method according to the present invention. The structure of the ferrite cores shown is but one example of the types of ferrite cores that could be manufactured according to the process of the present invention. It should be evident that although alumina is the preferred material for depositing onto the sides of the ferrite core for the protection of the edges, other materials could be used without departing from the present invention. The sputtering apparatus disclosed herein is but one example of vacuum deposition apparatus that may be used for the present invention.

Various vacuum deposition apparaus and methods of operation usable in the present invention are described in a book entitled "Handbook of Thin Film Technology", edited by L. J. Maissel and R. Glang, McGraw-Hill Book Company.

**Claims**

1. A process for depositing films on both sides of a plurality of thin magnetic head substrates (10), comprising the steps of,

placing a plurality of said substrates in a vacuum deposition sputtering apparatus (44) around a circle into recesses (88) of an annular stationary fixture (62), with an air bearing surface (18) of each substrate being exposed, with the sides of each substrate perpendicular to a circular target (50) of the film material to be deposited and such that the surfaces of both sides of each substrate are essentially positioned on a radius of the circle, with the particle deposition centre (86) of the system being the centre of the circle,

pumping down the sputtering apparatus with a vacuum pump (84),

operating the sputtering apparatus to sputter etch the sides of the placed substrates,

operating the vacuum deposition sputtering apparatus so that a film layer of the target material is deposited on all exposed surfaces of the thus placed substrates, and

removing the substrates from the apparatus after the required film thickness is obtained from the operated apparatus.

2. A process according to claim 1, in which the thin substrates are ferrite cores (10), comprising edge bonded ferrite material and non-magnetic ceramic material.

3. A process according to claim 2, in which the air bearing surfaces of the ferrite cores are lapped to remove the deposited material from the air bearing surfaces of the removed substrates to expose the transducing gaps.

4. A process according to claim 2 or 3, in which the target material is alumina.

### Patentansprüche

1. Verfahren zur Abscheidung von dünnen Schichten auf beiden Seiten einer Anzahl von dünnen Magnetkopfsubstraten (10), mit den Verfahrensschritten des

Anordnens einer Anzahl der Substrate in einer Vakuumabscheidungs-Sputtervorrichtung (44) längs eines Kreises in Ausnehmungen (88) einer ringförmigen stationären Befestigungsvorrichtung (62) so, daß eine Luftlagerfläche (18) eines jeden Substrats freiliegt, daß die Seiten eines jeden Substrats senkrecht zu einem kreisförmigen Target (50) des abzuscheidenden Dünnschichtmaterials sind, und so, daß die Flächen beider Seiten eines jeden Substrats im wesentlichen auf einem Radius des Kreises angeordnet sind, wobei die Teilchenabscheidungsmitte (86) des Systems die Mitte des Kreises ist,

Auspumpens der Sputtervorrichtung mit einer Vakuumpumpe (84),

Betreibens der Sputtervorrichtung für ein Sputterätzen der Seiten der angeordneten Substrate,

Betreibens der Vakuumabscheidungs-Sputtervorrichtung so, daß eine Dünnschicht des Targetmaterials auf allen freiliegenden Flächen der so angeordneten Substrate abgeschieden wird, und

Entfernens der Substrate aus der Vorrichtung, nachdem die geforderte Dünnschichtdicke durch die betriebene Vorrichtung gewonnen ist.

2. Verfahren nach Anspruch 1, bei welchem die dünnen Substrate Ferritkerne (10) sind, welche randverbundenes Ferritmaterial und nicht-magnetisches Keramikmaterial umfassen.

3. Verfahren nach Anspruch 2, bei welchem die Luftlagerflächen der Ferritkerne zur Entfernung des abgeschiedenen Materials von den Luftlagerflächen der entfernten Substrate geläppt werden, um so die Wandlerspalte freizulegen.

4. Verfahren nach Anspruch 2 oder 3, bei welchem das Targetmaterial Aluminiumoxid ist.

### Revendications

1. Procédé pour déposer des films sur les deux côtés de plusieurs substrats minces (10) pour tête magnétique, comprenant les étapes consistant à:

disposer plusieurs desdits substrats dans un appareil (44) de dépôt sous vide par pulvérisation, autour d'un cercle dans des cavités (88) prévues dans un support (62) stationnaire annulaire, une surface (18) d'exposition à l'air de chaque substrat étant exposée, les côtés de chaque substrat étant perpendiculaires à une cible circulaire (50) du matériau pour film qui doit être déposé et de telle façon que les surfaces des deux côtés de chaque substrat, soient à peu près disposées sur un rayon du cercle, le centre (86) de dépôt de particules du dispositif étant le centre du cercle,

mettre sous vide par pompage l'appreil de pulvérisation à l'aide d'une pompe à vide (84),

faire fonctionner l'appareil de pulvérisation pour décaper par pulvérisation les côtés des substrats en place,

faire fonctionner l'appareil de dépôt sous vide par pulvérisation de telle façon qu'un couche de film du matériau de la cible, soit déposée sur toutes les surfaces exposées des substrats ainsi placés, et

retirer les substrats de l'appareil après avoir obtenu l'épaisseur de film requise à l'aide de l'appareil utilisé.

2. Procédé suivant la revendication 1, dans lequel les substrats fins sont des noyaux de ferrite (10), comprenant un matériau de ferrite et un matériau céramique non-magnétique raccordés par leurs bords.

3. Procédé suivant la revendication 2, dans lequel les surfaces d'exposition à l'air des noyaux de ferrite, sont poncées pour éliminer le matériau déposé des surfaces d'exposition à l'air des substrats retirés afin d'exposer les espaces transducteurs.

4. Procédé suivant la revendication 2 ou 3, dans lequel le matériau de la cible est de l'alumine.

0 090 081

FIG-1

FIG-S

1

Fig. 2

*FIG-3*

*FIG-4*